# FASCICULE DE BREVET EUROPEEN

(11) **EP 0 565 415 B1**
(45) Date de publication et mention de la délivrance du brevet: **29.12.1997**
(21) Numéro de dépôt: 93400865.7
(22) Date de dépôt: 02.04.1993
(51) Int. Cl.: C30B 11/00

(54) **Procédé de fabrication d'un lingot en oxyde supraconducteur à haute température critique**
Verfahren zur Herstellung einer Stange aus supraleitendem Oxidmaterial mit Hochsprungstemperatur
Process for preparing an ingot of high critical temperature superconducting oxide

(30) Priorité: 06.04.1992 FR 9204174
(43) Date de publication de la demande: 13.10.1993
(73) Titulaire: ALCATEL ALSTHOM COMPAGNIE GENERALE D'ELECTRICITE, 75008 Paris (FR)
(72) Inventeur: Belouet, Christian, F-92330 Sceaux (FR)
(74) Mandataire: Laroche, Danièle

(56) Documents cités:
- EP-A- 0 070 760
- EP-A- 0 474 566
- JOURNAL OF CRYSTAL GROWTH., vol.100, no.1/2, Février 1990, AMSTERDAM NL pages 286 - 292 PINOL ET AL 'High temeperature superconductor composites by a modified bridgman method'
- PATENT ABSTRACTS OF JAPAN vol. 13, no. 419 (C-637) 18 Septembre 1989 & JP-A-11 057 499 (TOSHIBA CORP.) 20 Juin 1989

## Description

La présente invention concerne un procédé de fabrication d'un lingot en oxyde supraconducteur à haute température critique appartenant notamment aux familles YBaCuO, BiSrCaCuO, TlBaCaCuO.

Le principe du procédé est un procédé de croissance de type péritectique à partir d'un milieu diphasé, mis en oeuvre habituellement dans un creuset. Il nécessite avant la solidification proprement dite des températures de traitement élevées, typiquement supérieures d'au moins 50°C à la température de solidification péritectique Tₚ de l'oxyde considéré (par exemple 1000°C environ pour l'YBaCuO). A ces températures l'oxyde supraconducteur est décomposé en un solide (par exemple la phase solide 211 Y₂BaCu0₅ pour YBa₂Cu₃O₇-x) et un liquide qui peut réagir avec les parois du creuset; il en résulte une dérive de la composition dans le diagramme de phase.

La solidification est très lente car il s'agit d'une réaction qui met en jeu notamment deux corps solides et un liquide; pour l'YBaCuO on a par exemple: 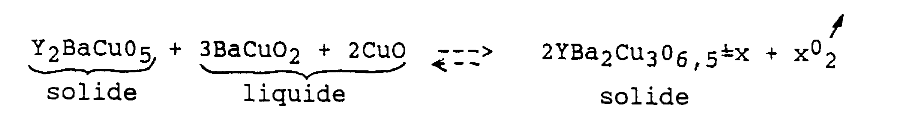 (avec x ≃ 0,5)

Idéalement la croissance du lingot devrait se faire au voisinage de la température péritectique Tₚ avec une faible surfusion; une forte surfusion entraînerait en effet l'inclusion de particules solides dans le front de croissance. De plus, cette croissance devrait se réaliser régulièrement, en régime non convectif, car des variations locales de la surfusion se traduiraient par des vitesses de croissance instantanées élevées, avec des risques de piégeages de particules solides dans le front de croissance.

Le procédé idéal de croissance d'un lingot devrait donc être un procédé de croissance lente en régime diffusionnel, mais cela impliquerait des temps de contact très prolongés à très haute température entre le liquide et le creuset, avec les conséquences néfastes déjà indiquées plus haut: dissolution partielle du creuset, modification du diagramme de phase, inclusion de phases parasites, précipités aux joints de grains etc..., avec pour conséquence la destruction partielle de la texturation du lingot final et la présence de précipités de grandes tailles dans celui-ci. A cela il faut ajouter la formation de fissures dues à la différence des coefficients de dilatation du creuset et du lingot, le lingot adhérant au creuset.

Toutes ces perturbations entraînent in fine une réduction de la densité de courant critique J_{c} et empêchent la préparation de lingots de grande taille, par exemple de l'ordre de 50 cm³.

La présente invention a pour but de mettre en oeuvre un procédé de fabrication d'un lingot en oxyde supraconducteur à haute température critique par fusion-solidification , permettant d'aboutir a une texture cristallographique aussi voisine que possible de celle d'un monocristal.

La présente invention a pour objet un procédé de fabrication par fusion-solidification d'un lingot en oxyde supraconducteur a haute température critique appartenant notamment aux familles YBaCuO, BiSrCaCuO, TlBaCaCuO, caractérisé par le fait que l'on part d'un lingot en oxyde ayant la stoechiométrie adéquate, qu'on le maintient horizontalement par lévitation sur un film gazeux à l'intérieur d'un four, qu'on le fond, qu'on établit un gradient thermique vertical dans ledit four de manière à ce qu'une nucléation démarre à la partie inférieure dudit lingot, que, tout en maintenant ledit gradient thermique, on abaisse globalement la température du four à une vitesse inférieure ou égale à 0,1°C/heure, jusqu'à la température correspondant a une solidification complète, et qu'on applique enfin audit lingot un traitement classique d'oxygénation.

Selon un mode de réalisation avantageux ledit gradient thermique vertical est de l'ordre de 10°C par centimètre.

Selon un perfectionnement, on règle la température cela partie inférieure du lingot, pour que ladite nucléation démarre seulement à une extrémité de ce lingot, puis, croisse lentement jusqu'à l'autre extrémité.

Cette phase intermédiaire peut durer plusieurs dizaines d'heures pour un lingot d'une dizaine de centimètres de longueur.

On réalise ainsi a la base dudit lingot une texture unique avec des plans (a, b) continus entre cristallites.

Au cours de l'abaissement progressif de la température et maintien du gradient thermique vertical, la croissance se fait à partir de cette texture de base dans le sens vertical. Durant toute cette phase de solidification la température de l'interface de croissance reste très voisine de la température péritectique Tₚ.

Préférentiellement on réalise la lévitation par l'intermédiaire de membranes poreuses en magnésie dont la perméabilité est de l'ordre de 1 à 2.10⁻¹⁵m².

Grâce à la lévitation sur film gazeux le lingot est autosupporté, ce qui facilite la diffusion de l'oxygène dans ce lingot à partir de sa surface extérieure.

Avantageusement la composition du gaz de lévitation peut être ajustée pour mener à bien ledit traitement d'oxygénation. Par exemple le gaz peut être de l'oxygène pur à partir de 600°C pour les composés de la famille YBaCuO.

Selon un perfectionnement on applique au lingot pendant sa fusion et sa solidification un champ magnétique vertical de l'ordre de 1 à 3 Teslas. Un tel champ magnétique accroît la viscosité apparente du milieu et réduit ainsi les convections qui pourraient y apparaître.

Le procédé selon l'invention sans contact permet d'éviter tous les inconvénients dus au creuset de l'art antérieur (dérive de composition, nucléation-croissance spontanée et désordonnée sur les parois, contraintes thermomécaniques); les causes les plus importantes de fracture sont supprimées et on aboutit à une texture homogène constituée de grains de grande dimension avec une valeur de densité de courant critique proche de celle d'un monocristal.

D'autres caractéristiques et avantages de la présente invention apparaîtront au cours de la description suivante d'un mode de réalisation donné a titre illustratif, mais nullement limitatif. Dans le dessin annexé:
- La figure 1 est une vue partielle très schématique en coupe de la partie centrale d'un dispositif permettant la mise en oeuvre du procédé selon l'invention.
- La figure 2 est une vue partielle très schématique en coupe d'une extrémité du dispositif de la figure 1.

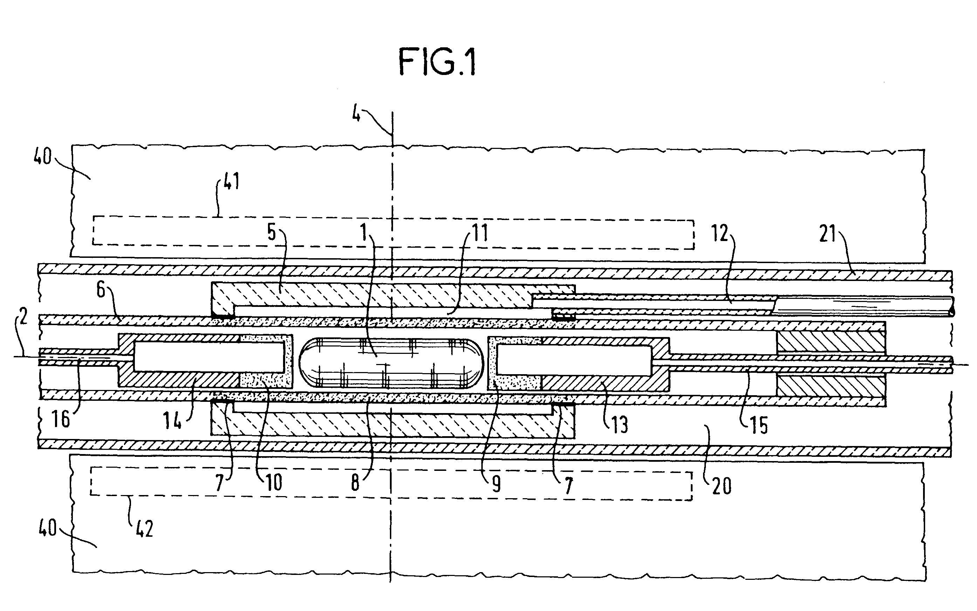

On voit dans la figure 1 un lingot 1 obtenu par pressage isostatique d'un mélange de poudres de BaCuO₂, Cu0 et Y₂0₃, dans les proportions stoechiométriques correspondant à YBa₂Cu₃0₇₋ₓ. Sa densité est élevée, de préférence supérieure ou égale à 0,70. Ce mélange poudreux est fritté.

Ses dimensions sont les suivantes:
- diamètre ≤ 19,85 mm
- longueur : 50 mm
(la longueur peut être plus importante, au moins égale à 200 mm).

Ce lingot 1 est introduit dans un dispositif de lévitation constitué principalement de deux parties coaxiales d'axe 2 et présentant un plan de symétrie 4 orthogonal à l'axe 2: il s'agit d'un corps extérieur creux 5 en forme de tube, et d'un tube tube intérieur 6. Ils sont tous les deux en céramique et solidarisés entre-eux par des scellements 7. La partie du tube 6 intérieure au tube 5 constitue une membrane poreuse 8 diffusante de diamètre intérieur 20,0 mm et de longueur au moins égale à 400 mm. De part et d'autre de la membrane 8 proprement dite, le diamètre intérieur du tube 6 est de 20,5 mm (cette différence n'est pas visible sur la figure 1).

De préférence la céramique de cette membrane 8 est la magnésie qui est très peu mouillée par les composés du lingot 1. La membrane 8 et le tube 5 forment entre-eux une cavité 11 alimentée en gaz de lévitation par l'intermédiaire d'une tubulure 12.

A l'intérieur du tube 6 sont disposés de part et d'autre du lingot 1 deux pistons 13 et 14, munis en direction de ce lingot de deux membranes diffusantes 9 et 10, de même nature que la membrane 8, et alimentées en gaz de lévitation par l'intermédiaire de tubulures ménagées à l'intérieur des tiges coulissantes 15 et 16. Le diamètre extérieur des deux pistons est choisi égal a 19,85 mm.

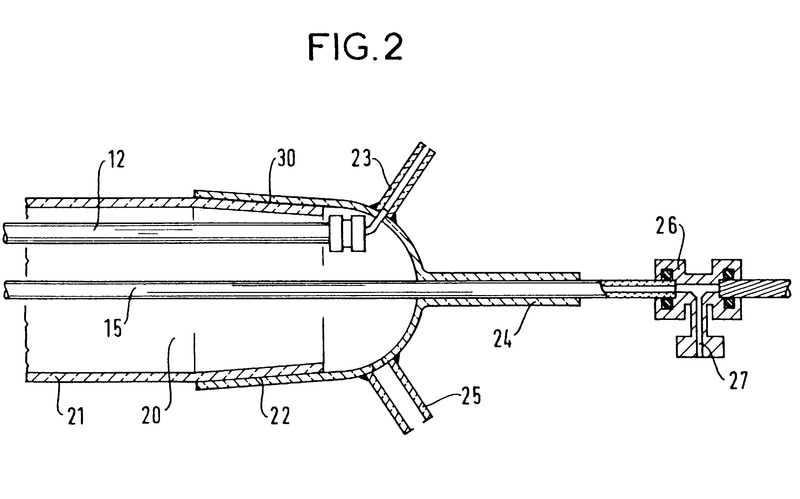

L'ensemble qui vient d'être décrit est disposé dans une enceinte étanche 20 constituée d'un tube de silice 21 fermé en 30 par deux capuchons 22 dont l'un est visible dans la figure 2.

Ce capuchon est muni de divers orifices 23, 24, 25. L'orifice 23 permet l'alimentation en gaz de la membrane 8; l'orifice 25 permet de faire le vide dans l'enceinte 20; l'orifice 24 sert d'une part à la translation de la tige 15 couplée en 26 à un moteur non illustré, et d'autre part à l'alimentation en gaz de la membrane 9 (voir référence 27).

De préférence le gaz de lévitation est un mélange d'argon et d'oxygène, par exemple respectivement 80% - 20% en volume, mais la proportion d'oxygène peut être augmentée.

L'enceinte 20 est disposée dans un four tubulaire 40 alimenté par des cartouches 41, 42 disposées parallèlement à l'axe 2, à l'intérieur d'une couronne en céramique, par exemple en zircone stabilisée, de diamètre intérieur 55 mm et de diamètre extérieur 80 mm; elles sont arrangées de manière non symétrique pour créer un gradient de température entre le bas et le haut du lingot 1. La puissance de chaque cartouche doit pouvoir être ajustée pour obtenir un gradient vertical dans la partie médiane du four de 10°C/cm.

On utilise l'installation qui vient d'être décrite, par exemple de la façon suivante.

On commence par faire le vide dans l'enceinte 20 (orifice 25) pour dégazer le lingot 1, et on commence le chauffage sans lévitation jusqu'à 600°C.

On met alors le lingot 1 en lévitation grâce aux membranes 8, 9 et 10 dont on contrôle la pression de diffusion par tout moyen connu.

On chauffe rapidement jusqu'à 1050°C, le lingot en fusion étant toujours maintenu confiné par les trois membranes. A titre indicatif la pression en aval des membranes est de 700 mbars pour une hauteur de lingot inférieure à 20 mm et une perméabilité des membranes de l'ordre de 1 à 2.10⁻¹⁵ m².

Pendant quinze minutes environ on maintient la température à 1050°C de manière homogène a l'intérieur du four 40. Puis la température est abaissée jusqu'à la température péritectique Tₚ, soit environ 1000°C.

Par le réglage des cartouches chauffantes 41 et 42 on abaisse la température des cartouches inférieures et on impose alors un gradient de température vertical dans le four de 10°C/cm, pour qu'une nucléation primaire se produise à la base du lingot 1. Mais on crée en outre un gradient thermique, longitudinal de manière que cette nucléation ne puisse commencer qu'au niveau d'une extrémité du lingot par exemple l'extrémité voisine de la membrane 9. Ce gradient est par exemple de quelques degrés par centimètre. Le front de croissance s'étend très lentement jusqu'à l'autre extrémité du lingot; cette phase dure quelques dizaines d'heures pour que la base du lingot soit parfaitement texturée.

On abaisse ensuite la température de l'ensemble du four à une vitesse inférieure à 0,1°C par heure jusqu'à et au-delà de la solidification complète du lingot. La température de la surface supérieure du lingot 1 est légèrement inférieure à Tₚ à la fin de cette phase.

A 700°C le processus d'oxydation du lingot solide 1 se traduit par une dilatation relativement importante en volume. Il est alors nécessaire de déplacer le lingot 1 au moyen des pistons 13 et 14 hors de la zone de lévitation, c'est-à-dire hors de la membrane 8 où le diamètre du tube 6 est de 20,5 mm.

On poursuit alors la descente de la température à 1°C/heure jusqu'à la température ambiante après avoir fait des paliers de plusieurs heures a 600°C, 500°C et 400°C.

Le lingot obtenu présente une forme cylindrique aplatie à sa partie supérieure; il est fortement texturé avec des grands grains dont l'axe C est vertical et parallèle au plan médian axial du lingot.

Bien entendu l'invention n'est pas limitée au mode de réalisation qui vient d'être décrit. On pourra, sans sortir du cadre de l'invention, remplacer tout moyen par un moyen équivalent.

## Revendications

1. Procédé de fabrication par fusion-solidification d'un lingot en oxyde supraconducteur à haute température critique appartenant notamment aux familles YBaCuO, BiSrCaCuO, TlBaCaCuO,
caractérisé par le fait que l'on part d'un lingot (1) en oxyde ayant la stoechiométrie adéquate, qu'on le maintient horizontalement par lévitation sur un film gazeux à l'intérieur d'un four (40), qu'on le fond, qu'on établit un gradient thermique vertical dans ledit four de manière à ce qu'une nucléation démarre à la partie inférieure dudit lingot (1), que, tout en maintenant ledit gradient thermique on abaisse globalement la température du four à une vitesse inférieure ou égale à 0,1°C/heure jusqu'à la température correspondant à une solidification complète, et qu'on applique enfin audit lingot un traitement classique d'oxygénation.

2. Procédé de fabrication selon la revendication 1, caractérisé par le fait que préalablement à la phase d'abaissement global de la température du four, on règle la température à ladite partie inférieure du lingot pour que ladite nucléation démarre seulement à une extrémité de ce lingot, puis croisse lentement jusqu'à l'autre extrémité.

3. Procédé de fabrication selon l'une des revendications précédentes, caractérisé par le fait que ledit gradient thermique vertical est de l'ordre de 10°C par centimètre.

4. Procédé de fabrication selon l'une des revendications précédentes, caractérisé par le fait que l'on réalise la lévitation par l'intermédiaire de membranes poreuses (8, 9, 10) en magnésie dont la perméabilité est de l'ordre de 1 à 2.10⁻¹⁵m².

5. Procédé selon l'une des revendications précédentes, caractérisé par le fait que, pendant la fusion et la solidification du lingot, on lui applique un champ magnétique vertical de l'ordre de 1 à 3 Teslas.

6. Procédé selon l'une des revendications précédentes, caractérisé par le fait que le gaz de lévitation contient un mélange d'argon et d'oxygène, avec au moins 20% d'oxygène en volume.

## Patentansprüche

1. Verfahren zur Herstellung eines Barrens aus einem supraleitenden Oxid mit hoher kritischer Temperatur, der insbesondere zu den Familien YBaCuO, BiSrCaCuO, TlBaCaCuO gehört, durch Schmelzen und anschließendes Verfestigen, dadurch gekennzeichnet, daß man von einem Barren (1) aus einem Oxid mit der geeigneten Stöchiometrie ausgeht, daß man ihn durch Levitation waagrecht auf einer Gasschicht innerhalb eines Ofens (40) hält, daß man den Barren schmilzt und einen vertikalen Temperaturgradienten in dem Ofen so herstellt, daß eine Keimbildung im unteren Teil des Barrens (1) beginnt, daß unter Beibehaltung des Temperaturgradienten global die Temperatur des Ofens mit einer Geschwindigkeit von höchstens 0,1°C/h bis zur Temperatur abgesenkt wird, bei der eine vollständige Verfestigung erfolgt, und daß man schließlich den Barren einer üblichen Sauerstoffanreicherungsbehandlung unterwirft.

2. Herstellungsverfahren nach Anspruch 1, dadurch gekennzeichnet, daß vor der Phase, bei der global die Temperatur des Ofens abgesenkt wird, die Temperatur im unteren Teil des Barrens so eingestellt wird, daß die Keimbildung nur an einem Ende des Barrens beginnt und dann langsam bis zum anderen Ende fortschreitet.

3. Herstellungsverfahren nach einem der vorhergehenden Ansprüche, dadurch gekennzeichnet, daß der vertikale Temperaturgradient bei etwa 10°C je cm liegt.

4. Herstellungsverfahren nach einem der vorhergehenden Ansprüche, dadurch gekennzeichnet, daß die Levitation mit Hilfe poröser Membranen (8, 9, 10) aus Magnesiumoxid erfolgt, deren Gasdurchlässigkeit bei etwa 1 bis 2·10⁻¹⁵m² liegt.

5. Verfahren nach einem der vorhergehenden Ansprüche, dadurch gekennzeichnet, daß während des Schmelzens und der Verfestigung des Barrens ein vertikales Magnetfeld von etwa 1 bis 3 Tesla an ihn angelegt wird.

6. Verfahren nach einem der vorhergehenden Ansprüche, dadurch gekennzeichnet, daß das Levitationsgas eine Mischung aus Argon und Sauerstoff mit mindestens 20 Vol.% Sauerstoff enthält.

## Claims

1. A melting-and-solidification manufacturing method for manufacturing an ingot of a high critical temperature superconductive oxide belonging, in particular, to the YBaCuO, BiSrCaCuO, or TlBaCaCuO families;
said method being characterized by the facts that an ingot (1) of oxide having the appropriate stoichiometery is used, that the ingot is held horizontally by levitation on a film of gas inside a furnace (40), that the ingot is melted, that a vertical thermal gradient is established inside said furnace such that nucleation starts at the bottom portion of said ingot (1), that, while maintaining said thermal gradient, the overall temperature of the furnace is lowered at a rate of not more than 0.1°C/hour down to the temperature which corresponds to complete ingot solidification, and that, finally, conventional oxygenation treatment is applied to said ingot.

2. A manufacturing method according to claim 1, characterized by the fact that, prior to the stage during which the overall temperature of the furnace is lowered, the temperature of said bottom portion of the ingot is adjusted such that said nucleation starts at only one end of the ingot, and then grows slowly to reach the other end.

3. A manufacturing method according to any preceding claim, characterized by the fact that said vertical thermal gradient is about 10°C per centimeter.

4. A manufacturing method according to any preceding claim, characterized by the fact that the levitation is performed via porous membranes (8, 9, 10) made of magnesium oxide, the permeability of the membranes lying in the approximate range 1.10⁻¹⁵ m² to 2.10⁻¹⁵ m².

5. A method according to any preceding claim, characterized by the fact that while the ingot is being melted and solidified, a vertical magnetic field lying in the approximate range 1 tesla to 3 teslas is applied to the ingot.

6. A method according to any preceding claim, characterized by the fact that the levitation gas contains a mixture of argon and oxygen, with at least 20% of oxygen by volume.
